# EUROPÄISCHE PATENTSCHRIFT

(11) **EP 0 776 989 B1**
(45) Veröffentlichungstag und Bekanntmachung des Hinweises auf die Patenterteilung: **27.03.2002**
(21) Anmeldenummer: 96109376.2
(22) Anmeldetag: 12.06.1996
(51) Int. Cl.: C23C 16/26, C23C 16/02, G02B 1/10, C23C 16/32

(54) **Verfahren zur Herstellung einer farbgebenden Beschichtung**
Method of making a coloured coating
Procédé pour réaliser un revêtement coloré

(30) Priorität: 29.11.1995 DE 19544498
(43) Veröffentlichungstag der Anmeldung: 04.06.1997
(73) Patentinhaber: ANTEC Angewandte Neue Technologien GmbH, D-65779 Kelkheim (DE)
(72) Erfinder: Hartmann, Rolf, Dipl.-Ing., 65779 Kelkheim (DE); Ronge, Werner, Dipl.-Ing., 64546 Mörfelden-Walldorf (DE); Tschentscher, Armin, Dipl.-Ing., 65439 Flörsheim (DE)
(74) Vertreter: Lippert, Marianne

(56) Entgegenhaltungen:
- EP-A- 0 267 679
- DE-A- 3 202 709
- GB-A- 2 165 266

## Beschreibung

Die Erfindung betrifft ein Verfahren zur Herstellung einer farbgebenden Beschichtung, bei dem mittels eines CVD-Verfahrens der Dünnschichttechnik eine Schicht aus einem kohlenstoff- und siliziumhaltigen Arbeitsgas abgeschieden wird. Das Verfahren dient zur Farbgebung von Gegenständen mit breiter Farbpalette auf beliebiger Substratoberfläche über die Herstellung einer Beschichtung, welche die beschichteten Gegenstände vorzugsweise gleichzeitig und unabhängig von dem jeweiligen Farbeindruck mit einem wirksamen Verschleiß- und Korrosionsschutz hoher Härte versieht. Diese Beschichtung kann farbig in Regenbogenfarben bis Tiefschwarz, in Farbverläufen mit weichem Farbübergang oder strukturierte Farbfiguren oder bis zu harten Farbkontrasten, in unterschiedlichen Farbhelligkeiten bzw. Dunkelungsgraden, in irisierender Erscheinung hergestellt werden.

Die Erfindung geht aus von einem Verfahren mit den Merkmalen im Oberbegriff des Patentanspruchs 1, wie sie beispielsweise aus der EP 0 509 875 A1 bekannt sind.

Bei der konventionellen Farbgebung von Gegenständen durch Auftragen einer Körperfarbe (z.B. durch Lackieren) entstehen stets relativ dicke und weiche Schichten von mindestens einigen Mikrometern Dicke, wobei die Oberfläche stets mehr oder weniger Eigenstruktur (Orangenhaut) zeigt und meist die bekannten Probleme mit Lösungsmitteln zu berücksichtigen sind. Die erzeugbaren Farben sind Körperfarben; deren Leuchtkraft ist naturgemäß begrenzt. Farb-Lackierungen sind im Vergleich zu Hartstoffschichten sehr weich und nicht ausreichend verschleißfest.

Bei PVD-Hartstoffschichten ist das Farbspektrum auf die typischen Körperfarben dieser Materialien begrenzt, zudem eignen sich Hartstoffschichten wegen ihrer stengeligen Mikrostruktur kaum als Korrosionsschutz.

Teile aus Aluminiumwerkstoffen können bekanntermaßen durch spezielle Eloxalverfahren eingefärbt werden, wobei relativ dicke und harte Oberflächenschichten erzeugt werden. Diese Schichten sind ohne Eigenstruktur, auch nachträglich einfärbbar, in der Anwendung allerdings aber auf Aluminiumwerkstoffe begrenzt.

Weiche Farbverläufe sind mit Eloxalverfahren, die eine hohe Oberflächenhärte erreichen, nicht oder nur sehr eingeschränkt realisierbar. Lackierverfahren, die Farbverläufe ermöglichen, liefern Schichten, die, wie bereits erwähnt, wiederum sehr weich und nicht verschleißfest sind.

Irisierende Farbeindrücke auf metallisch glänzenden Oberflächen werden bereits durch Aufbringen mehrlagiger Schichtsysteme erzeugt, die meist aus wechselnden Lagen oxidischer oder fluoridischer Metallverbindungen unterschiedlicher Brechzahl bestehen. Zwar ist dem so erzeugbaren Farbeindruck wegen der optischen Reflexion eine hohe Leuchtkraft eigen, doch ist stets das aufeinanderfolgende Aufbringen von mehreren dünnen Schichten mit genau aufeinander abgestimmter Schichtdicke erforderlich. In G. Kienel, Vakuum-Beschichtung 5, Anwendungen Teil II; VDI-Verlag; (1993) S.84 wird die Herstellung irisierender Schichten auf der Basis einer ungeraden Anzahl abwechselnd thermisch aufgedampfter Schichten aus Zinksulfid und Magnesiumfluorid beschrieben. Schichtstapel dieser Art bieten keinen nennenswerten Verschleiß- und Korrosionsschutz.

Farbige Beschichtungen können auch durch Einbringen von Metallpartikeln in eine farblose Schicht erzeugt werden, jedoch ist das Spektrum der so erzeugbaren Körperfarben auf die typischen Farben der Metalle beschränkt.

Der Erfindung liegt die Aufgabe zugrunde, ein Verfahren zur Herstellung einer farbgebenden Beschichtung anzugeben, das die oben genannten Nachteile und insbesondere den der Beschränkung auf typische Körperfarben vermeidet. Diese Aufgabe wird durch die Merkmale des Patentanspruchs 1 gelöst. Vorteilhafte Weiterbildungen der Erfindung sind in den Unteransprüchen definiert.

Erfindungsgemäß wird danach eine Beschichtung hergestellt, die sich im Vakuum unter dem Einfluß einer elektrisch angeregten Plasmaentladung aus einem kohlenstoff- und Siliziumhaltigen Arbeitsgas, bis zu einer vordefinierten Dicke auf den zu beschichtenden Teilen abscheidet.

Das erfindungsgemäße Verfahren ermöglicht im Gegensatz zum Stand der Technik eine einfach realisierbare und gezielte Farbgebung bei unterschiedlichen Substraten ohne Einschränkung der Farbpalette, z.B. auf Körperfarben oder komplizierte Schichtaufbauten aus unterschiedlichen Materialien usw., das einfach, lösemittelfrei, kalt und umweltfreundlich arbeitet und dünne Beschichtungen erzeugt, welche die Oberflächenstruktur der Teile als Finish nicht beeinträchtigen. Gleichzeitig wird den damit überzogenen Gegenständen eine erhöhte Resistenz gegen Umwelteinflüsse und Korrosion verliehen.

Überraschenderweise gelang es darüber hinaus, in dem einzigen Vakuum-Beschichtungsprozeß zur Farbgebung gleichzeitig die Härte und Verschleißbeständigkeit der Beschichtung erheblich zu steigern und eine einzige, harte und verschleiß- sowie korrosionsfeste Schicht mit darin fest integriertem farbgebenden Bereich zu erzeugen. Mit anderen Worten gelang es entgegen den bisherigen Erfahrungen mit üblichen dünnen Interferenzschichten, eine relativ dicke und verschleißfeste Schicht additiv mit einer Farbgebung zu realisieren und so die erfindungsgemäßen Interferenz-Beschichtungen auch mit außerordentlicher Härte und Beständigkeit herzustellen.

Erfindungsgemäß werden hierzu in der wachsenden Schicht durch Veränderung der Beschichtungsparameter, insbesondere der Zusammensetzung der schichtbildenden Gasphase und/oder der elektrischen Parameter der Energieeinspeisung ein oder mehrere in vorgegebener Weise definierte Gradienten (sprungartig oder stetig) erzeugt. Diese Gradienten beeinflussen die optischen Eigenschaften der Beschichtung so, daß Lagen oder Bereiche unterschiedlicher Brechzahl wachsen, an deren optisch reflektierenden Grenzflächen die farbgebenden Interferenzeffekte nach Anspruch 1 entstehen. Dabei wird die Beschichtung im nicht farbgebenden Schichtbereich und in dem oder den farbgebenden Schichtbereichen so eingestellt, daß die gewünschte Härte und Verschleißfestigkeit erzielt werden, daß sich einerseits die unterschiedlichen Brechzahlen der Schichtbereiche ergeben und sich andererseits die Härten dieser Schichtbereiche nicht wesentlich voneinander unterscheiden und daß diese Schichtbereiche unlösbar miteinander verbunden sind.

Die farbgebende oder farbbestimmende Zone der Beschichtung ist damit ein Teil der schützenden Beschichtung, weist die gleichen mechanischen Eigenschaften (Härte und Verschleißbeständigkeit) wie diese auf und ist von dieser praktisch nicht entfernbar. Erfahrungsgemäß wird bei extremen mechanischen Belastungen eines erfindungsgemäß beschichteten Gegenstandes zuerst der Grundwerkstoff beschädigt und gibt nach, bevor die Beschichtung oder Teile davon abgelöst werden können.

Die Gesamtdicke der Beschichtung wird den jeweiligen Anforderungen an die Verschleißfestigkeit unabhängig von der gewünschten Farbe angegepaßt, die gegen Ende der Beschichtung hervorgerufen wird.

Mit anderen Worten wird zunächst bis zu Erzielung einer vorzugsweise im wesentlichen schwarzen diamantartigen Schicht einiger µm Dicke der gewünschten Härte bechichtet, dann kurz vor Ende der Beschichtung die Beschichtungsparameter in der oben definierten Weise zumindest mit einem Brechzahlsprung oder stetigen Brechzahlgradienten geändert und bis zur Einstellung des gewünschten Farbeindrucks weiter beschichtet, wobei anschließend wahlweise noch eine oder mehrere weitere farbgebende Schichten nach den, entsprechende Refeflexionsgrenzflächen hervorrufenden, Brechzahlgradienten aufgebracht werden.

Hingegen hatten zahlreiche auf andere Weise von den Erfindern hergestellte Beschichtungssysteme nicht zu derartig beständigen, harten und gleichzeitig farbigen Beschichtungen geführt. So wurden z.B. nachträglich farbige diamantartige Interferenzbeläge nach Aufbringen einer reflektierenden Zwischenschicht auf einer verschleißfesten harten, diamantartigen Schicht abgeschieden oder es wurden die Interferenzschichten mit diversen farblosen Schichten überzogen. Bei Belastung wurden jedoch diese Schichtverbunde zerstört und der farbgebende Belag konnte nicht mit der gewünschten Härte und Verschleißfestigkeit erzielt werden.

Als weiterer Vorteil des erfindungsgemäßen Verfahrens kommt hinzu, daß man durch Integration in die dickere verschleißfeste Schicht weitestgehend unabhängig von der Substratoberfläche wird und insbesondere keine reflektierenden (z.B. aufwendig polierten) Substratoberflächen als optische Grenzfläche für den Interferenzeffekt mehr benötigt.

Der erfindungsgemäß benutzte Schichttyp beruht auf der plasmaunterstützten Gasphasenabscheidung von siliziumhaltigem diamantartigem Kohlenstoff. Die Verwendung von Schichten aus diamantartigem Kohlenstoff zur Oberflächenveredelung ist seit einiger Zeit bekannt. Diese grundsätzlich schwarzen Schichten sind verschleiß- und reibungsarm und zeichnen sich durch eine große Härte aus. Ein wichtiges Einsatzgebiet ist daher die Beschichtung zur Verminderung von Reibung und Verschleiß insbesondere bei bewegten Bauteilen. Bewährt hat sich wie im oben erwähnten gattungsgemäßen Verfahren, die reibmindernden Schichten durch elektrische Gasentladung aus einer Gasphase geeigneter Zusammensetzung nach dem PACVD-Verfahren (von Plasma Assisted Chemical Vapour Deposition) abzuscheiden. Auch in der EP 0182 889 B1 ist ein solches Verfahren dargelegt, das im Prinzip auch in der vorliegenden Erfindung angewandt wird, so daß für die Offenbarung des grundsätzlichen Verfahrensablaufs hier ausdrücklich auf diese Schrift verwiesen wird.

Bei diesem Verfahren gemäß der EP 0182 889 B1 wird mit einem Arbeitsgas aus reinem Kohlenwasserstoffgas und reinem Wasserstoff ohne jeden Zusatz von Silizium gearbeitet, dem bedarfsweise nur Edelgase zugesetzt werden. So können beschreibungsgemäß auf Glaskörpern, Edelstahl, Aluminium oder Keramiken harte und verschleißfeste, aber stets braune bis tiefschwarze, diamantartige Schichten erzielt werden, die zur frei wählbaren Farbgebung nicht geeignet sind.

Es stellte sich heraus, daß nach einem derartigen Verfahren hergestellte Schichten insbesondere bei kritischen Substraten wie einsatzgehärteten Stählen und kupferhaltigen Legierungen eine unzureichende oder gar keine Haftung zeigten, da diese Schichten häufig innere Druckspannungen aufweisen.

Durch den Zusatz von Silizium gemäß Oberbegriff des Patentanspruchs 1 zum kohlenstoffhaltigen Abscheidungsgas gelingt es, reib- und verschleißmindernde Schichten auch auf technische Grundwerkstoffe aufzubringen, die als unbeschichtbar oder schwer beschichtbar gelten, wie einsatzgehärtete oder nitrierte Stähle und kupferhaltige Verbindungen. Unter anderem wird dieser Zusatz von Silizium beschrieben: zur Minderung des Reibungskoeffizienten der erzeugten Schichten in der EP 0 435 312 A1, zur Verbesserung der Haftung auf dem Substrat in der DE 38 38 905, in Verbindung mit Methan zur Erniedrigung der Substrattemperatur während der Beschichtung in der US 4,873,114 und als Zusatz bei der Erzeugung von Schichten aus diamantartigem Kohlenstoff mittels LECVD ("Laser-excited Chemical Vapour Deposition") in der US 5,094, 915. Dabei werden zumeist schwarze Schichten von einigen Mikrometern Dicke erzeugt. Bei dünneren Schichten wurden im Stand der Technik mehr oder weniger schmutziggelbe bis braune Körperfarben der Schicht beobachtet (z.B. EP 0 509 875 A1).

Auf die Einfärbung von Werkstücken wurde in der DE 41 00 584 A1 hingewiesen. Ziel des diesbezüglichen Vorschlags war es, Verschleißbereiche frühzeitig zu erkennen, wenn eine durch Gold eingefärbte und markierte Unterschicht unter der siliziumfreien diamantartigen Schutzschicht nach deren Abtragung sichtbar wird.

Der erfindungsgemäße Zusatz von Silizium hingegen dient dem technischen Zweck der verbesserten Haftung auch auf kritischen Substraten oder des verminderten Reibkoeffizienten und bewirkt selbst keine Farbgebung als ein eine Körperfarbe einbringender Zusatz.

Erfindungsgemäß wird zur Farbgebung von z.B. metallischen Substraten in einem einzigen Vakuumprozeß mittels plasmaunterstützter chemischer Gasphasenabscheidung aus einer kohlenstoff- und siliziumhaltigen Gasphase bestimmter Zusammensetzung auf der Substratoberfläche eine im wesentlichen diamantartige und damit hochbrechende Schicht vorzugsweise aus einer Kohlenstoff-Silizium-Wasserstoff-Mischung abgeschieden, in welcher durch Variation der Zusammensetzung durch optische Übergänge separierte Bereiche entstehen. Die zusammenhängende Beschichtung gliedert sich damit in voneinander mechanisch nicht trennbare Bereiche mit unterschiedlicher Funktion: einen Schutzbereich, dessen Dicke nach den Erfordernissen der Verschleiß- und Korrosionsfestigkeit gewählt wird und einen oder mehrere farbgebende Bereiche mit optischer Wirkung, aber mit praktisch gleicher Härte.

Der resultierende Farbeindruck wird prinzipiell durch die Schichtdicken und Schichtdickenverhältnisse der einzelnen Bereiche bestimmt. Dabei wird die Schichtdicke des oder der farbgebenden Schichtbereiche so eingestellt, daß der durch sie bewirkte, optische Weglängenunterschied des an Vorder- und Rückseite des Bereichs reflektierten Lichts nach den Regeln der Optik das ein- oder ganzzahlige Mehrfache der Wellenlänge bzw. halben Wellenlänge des gewünschten Farbeindrucks beträgt. Damit liegt der optische Weglängenunterschied nΔx, der der optischen Dicke der Schicht entspricht, für die erste Ordnung der Interferenz etwa im Bereich von 0,5 µm. Die reale Schichtdicke eines solchen farbgebenden Bereichs liegt dann bei einer Brechzahl um n = 2 im Bereich von etwa 0,1 µm. Die Dicke der gesamten Beschichtung mit den integrierten farbgebenden Bereichen liegt je nach den Anforderungen hinsichtlich der Schutzwirkung im Bereich von etwa 0,1 µm bis zu mehrern Mikrometern und ist unabhängig vom gewünschten Farbeindruck nach den Erfordernissen der Verschleißfestigkeit wählbar.

Bei verschleißfesten, harten farbigen Schichten kann der untere nicht farbgebende Bereich prinzipiell beliebig dick sein, wobei in der Praxis Werte von etwa 1 bis 10 µm sinnvoll sind.

Grundlage der Entstehung des Farbeindrucks sind die bekannten optischen Eigenschaften dünner Plättchen. Verursacht durch Interferenzeffekte wird bevorzugt die Lichtwellenlänge reflektiert, deren Gangunterschied bei der Reflexion an Vorder- und Rückseite der farbgebenden Beschichtung bzw. des farbgebenden Schichtbereichs eine volle Wellenlänge beträgt. Beträgt der Gangunterschied ein Mehrfaches (Interferenz höherer Ordnung), so kann der Farbeindruck durch Überlagerung mit anderen, ebenfalls interferierenden Wellenlängen des Lichts geändert und nach Wunsch eingestellt werden. Voraussetzung für die erfindungsgemäße Realisierung eines intensiven Farbeffekts sind hohe Brechzahl-Unterschiede an den Schicht-Grenzflächen, verbunden mit einer niedrigen Extinktion bei der gewünschten Wellenlänge. Der Farbeindruck resultiert dann aus der Überlagerung und Interferenz des an den verschiedenen Grenzflächen reflektierten Lichts erster und/oder höherer Ordnung.

Schichten aus reinem diamantartigen Kohlenstoff ohne Silizium-zusatz sind bereits in geringer Schichtdicke schon sehr dunkel und erreichen bald ein tiefes Schwarz. Interferenzeffekte höherer Ordnung scheitern bei diesem Material an der dunklen Eigenfärbung der Schicht. Im Stand der Technik werden regelmäßig schwarze kratz- und verschleißfeste Schichten erzeugt, die ebenfalls nicht zur frei wählbaren Farbgebung geeignet sind.

Durch Zusatz von Silizium zum Schichtsystem aus diamantartigen Kohlenstoff, wie dies aus Gründen der Haftungsverbesserung bei dicken Verschleißschutzschichten im Bereich der Tribologie bereits beschrieben wurde, kann überraschenderweise die Extinktion dünner Schichten soweit reduziert werden, daß sehr effektive Interferenzeffekte nicht nur erster, sondern auch höherer Ordnung, d.h. Mischinterferenzen möglich werden. Im Verfahren kann während der Aufbringung des in der Beschichtung integrierten farbgebenden Schichtbereichs der Farbkreis also gezielt mehrfach durchlaufen werden und bei Erzielung des gewünschten Farbeindrucks die Beschichtung beendet werden. Über die kontinuierliche, leicht automatisierbare Kontrolle des Farbeindrucks während des Schichtwachstums ist der gewünschte Farbeindruck selbst bei Schwankung der Schichtparameter exakt reproduzierbar. Damit ist das Verfahren gegenüber bisherigen komplizierten Schichtsystemen erheblich vereinfacht.

Bei der Ausarbeitung des Verfahrens wurde ermittelt, daß keine Ausgangsmaterialien höchster Reinheit erforderlich sind. Alle Beschichtungen lassen sich mit Substanzen technischer Reinheit (Laborqualität) durchführen. Die Beschichtung kann in einem weiten Druckbereich durchgeführt werden. Der Arbeitsbereich liegt zweckmäßigerweise zwischen etwa 0,005 und 1 mbar, vorzugsweise bei etwa 0,05 mbar Gesamtdruck. Die Beschichtung wird aus der Gasphase ohne die Verwendung fester Quellen durchgeführt, wie in der EP 0182 889 B1 beschrieben, um eine effektive, allseitig gleichmäßige Beschichtung auch kompliziert geformter Teile vornehmen zu können. Der Silizium-Zusatz erfolgt vorteilhafterweise nicht in Form von selbstentzündlichem Silangas, sondern als verdampfbare siliziumorganische Verbindung, die zu dem den Kohlenstoff liefernden Gas beigemischt oder von diesem getrennt eingespeist wird, so daß die Mischung im Rezipienten erst unmittelbar vor der Beschichtung stattfindet. Als Ausgangsmaterialien werden vorteilhafterweise Ethin und Hexamethyldisiloxandampf benutzt; chemisch ähnliche und verwandte Verbindungen führen bei entsprechend angepaßten Abscheidungsparametern ebenfalls zum gewünschten Erfolg.

So wird das Silizium vorzugsweise in Form des Dampfes einer der siliziumorganischen Verbindungen Hexamethyldisilan (HMDS), Tetramethylsilan, Hexamethyldisiloxan (HMDSO), Tetraetoxisilan (TEOS) und Tetramethylsilazan, den übrigen Arbeitsgasstoffen, die neben den Kohlenstoffquellen wie z.B. Ethan, Ethen, Ethin oder Aromaten wie Benzol auch Edelgase und Wasserstoff umfassen können, beigemischt oder die Komponenten getrennt an unterschiedlichen Einlaßstellen in den Vakuumrezipienten eingeleitet.

Bei einer bevorzugten Verfahrensvariante wird das Arbeitsgas aus Ethin, Wasserstoff und Hexamethyldisiloxan mit einem molaren Mischungsverhältnis derart zusammengesetzt, daß bezogen auf die Menge des Kohlenwasserstoffgases Ethins, gesetzt zu 1, die Anteile von Wasserstoff zwischen 1 und 0,01 und die von Hexamethyldisiloxan zwischen 0,5 und 0,005 liegen. Weitere Dämpfe von Metallorganika, die ähnliche Bedingungen wie die siliziumhaltigen Anteile bewirken, können ebenfalls zugemischt oder auch ersatzweise verwendet werden. Zur Erzeugung der beschriebenen Gradienten in der Zusammensetzung und in der optischen Brechzahl der Schichten bzw. Schichtbereiche wird die Gaszusammensetzung innerhalb der oben angegebenen Grenzen gezielt variiert.

Wie im Anspruch 1 und 3 angegeben, wird dabei zunächst ein für den jeweils gewünschten Reflexionsgrad ausreichender Brechzahlsprung erzeugt, ohne jedoch andererseits einen spürbaren Sprung in den mechanischen Eigenschaften (Härte) zu erzeugen. Es wurden empirisch für verschiedene Gaszusammensetzungen bei unterschiedlichen Anforderungen an die mechanischen Eigenschaften der Beschichtung Brechzahlsprünge bestimmt, die den jeweils erwünschten Farbeffekt ergaben. Dann wurden die mechanischen Eigenschaften dieser farbigen Beschichtungen getestet. Als Kriterium für verwendbare Brechzahlsprünge bzw. -gradienten diente der Zusammenhalt des Schichtsystems bei vorgegebener mechanischer Belastung. Je nach Art und Intensität der Farbhelligkeit kann eine gewünschte und gezielte Variation des Brechzahlsprunges bzw. -gradienten gewählt werden, die von absoluter bis zu partieller Reflexion mit entsprechend dunklerer Tönung des Farbeindruckes reicht. Dies wird gezielt zur Beeinflussung der Farbhelligkeit genutzt, um die Zahl der realisierbaren Farben zu erweitern. Der Fachmann, dem für die zugrunde liegenden diamantartigen Schichten die Parameter zur Beeinflussung der Schichthärte zur Verfügung stehen, kann die für seine jeweiligen Zwecke (Härte, Farbton, Farbintensität) besten Werte auf der Grundlage der angegebenen prinzipiellen Verfahrensweise ohne weiteres ermitteln.

Wird zur Erzeugung der gewünschten Reflexionsfläche eine Schicht abweichender, niedrigerer Brechzahl erzeugt, so kann an dieser unter geeigneten Bedingungen nach den Gesetzen der Optik Totalreflexion auftreten. Wird diese Zwischenschicht jedoch sehr dünn ausgeführt (deutlich weniger als eine Wellenlänge), so tritt die sogenannte abgeschwächte Totalreflexion auf; der Reflexionsgrad geht zurück, der Untergrund scheint durch. Auf diese Weise können erfindungsgemäß nicht nur sehr leuchtende, sondern auch gedeckte Farben von besonders edlem Aussehen erzeugt werden, wobei die Wellenlängenabhängigkeit des Effekts als weiterer Parameter zur Steuerung des Farbeindrucks genutzt werden kann.

Es wurden verschiedene einfache und hintereinander geschaltete Zwei- oder Mehrfachsprünge der Brechzahl (sowohl mit ab- als auch zunehmendem Gradienten) realisiert, wobei stets dafür zu sorgen ist, daß das auf das beschichtete Substrat fallende Licht mindestens eine Reflexionsfläche zu einem optisch dichteren Medium findet. Ändert man die Brechzahl bzw. Zusammensetzung beim Aufwachsen der Schicht stetig, so erhält man gleichzeitig eine Vielzahl von in Schichtdickenrichtung verschieden tief liegenden Reflexionsgrenzflächen.

Die Beschichtung kann durch Variation der interferenzbestimmenden Schichtdicken durch Beeinflussung der Abscheidebedingungen örtlich so eingestellt werden, daß Farbfiguren in Farbverläufen mit weichem Farbübergang oder strukturierte Farbeffekte entstehen. Die Einstellung erfolgt durch Beeinflussung der Gasführung und/oder der elektrischen Felder, die für die Abscheidung bestimmend sind.

Für die optische Wirksamkeit der erfindungsgemäßen Beschichtung wird die elektrische Plasma-Anregung so gewählt, daß sich der diamantartige Charakter der Schicht ergibt. In den Ausführungsbeispielen wurde das Plasma mit Hochfrequenzenergie (13,56 MHz) angeregt, wobei sich durch die spezielle Art der Energieeinkopplung aus geometrischen Gründen bei vorgegebener Plasmaleistung eine am Substrat zu messende Self-Bias-Spannung ergibt, die je nach Grundwerkstoff zwischen 30 V und 1000 V, maximal 1500 V beträgt. Andere Arten der Anregung, auch aus verschiedenenen Energiequellen gleichzeitig, können ebenfalls zum Erfolg führen, solange während des Schichtwachstums durch die Wechselwirkung des Plasmas mit der Schicht z.B. durch Ionenbeschuß die diamantartige Struktur erzeugt wird.

Die neuen farbgebenden Schichten bringen einen entscheidenden technischen Fortschritt für die integrierte Farbgebung und Oberflächenvergütung von praktisch beliebigen Gegenständen. Neben der breiten Farbpalette steht damit auch die Verschleiß- und Korrosionsbeständigkeit als Nutzen zur Verfügung. So können Chromarmaturen und -beschläge ohne nachteilige und oft gar nicht zulässige Lackierungsmaßnahmen in vielen Farben durch Überziehen mit der erfindungsgemäßen Beschichtung vorgegebener Dicke hergestellt werden. Zusätzlich ergibt sich der Vorteil, daß durch diese Beschichtung die Oberfläche der Gegenstände verschleißfest und korrosionsbeständig vergütet wird. Durch Vergrößern der farbgebenden Schichtdicke bzw. des Schichtbereichs lassen sich auch gedecktere Farbtöne erzielen. Hierbei werden gezielt nicht die erste, sondern höhere Ordnungen des Interferenzeffekts ausgenutzt, so daß durch Überlagerung verschiedener Interferenzeffekte andere, neuartige Farbeindrücke größerer Farbtiefe eingestellt werden können, und/oder auf die schon beschriebene Weise die Farbhelligkeit variiert wird.

So ist es möglich, für Beschläge, Armaturen usw. auch vergleichsweise kostengünstige Grundwerkstoffe zu nehmen, die erfindungsgemäß in jedem Falle beschichtbar sind, ihnen eine gewünschte Farbe verleihen und gleichzeitig bedarfsweise die für ihren Gebrauch erforderliche Härte, Korrosions- und Verschleißfestigkeit zu erzeugen.

In den Ausführungsbeispielen zur Herstellung der erfindungsgemäßen Schichten wurde eine Unterdruckkammer eingesetzt, die mittels mechanischer Pumpen auf den Arbeitsdruck zwischen 0,2 bis 0,01 mbar gebracht wurde. Eine Evakuierung mit Hochvakuumpumpen war nicht erforderlich. In diesem Raum wurde das Reaktionsgemisch eingeleitet, wobei sich zwischen der eingeleiteten Menge und dem Saugvermögen der Pumpe ein dynamisches Gleichgewicht bei dem genannten Druckwert einstellte.

Die Unterdruckkammer wies ein Volumen von etwa 100 Liter auf. Zur Aufrechterhaltung der elektrischen Entladung in diesem Volumen und zur Schichtbildung war eine Hochfrequenzleistung von etwa 100 bis 300 Watt erforderlich. Die optische Dicke der aufgebrachten Schichten wurde über eine mechanische Dickenmessung und die Bestimmung des Brechungsindex der Schichten ermittelt.

Zur Erzeugung der Beschichtung wurden die zu beschichtenden Teile mit Hochfrequenzenergie (13,56 MHz) versorgt, wobei leitfähige Teile über eine Impedanzanpassung direkt mit dem Ausgang des Hochfrequenzgenerators verbunden wurden und isolierende Teile so mit einer rückseitig angebrachten metallischen Elektrode versehen wurden, daß auch an deren vorderseitiger, zu beschichtender Oberfläche das elektrische Feld der Hochfrequenzenergie und deren Self-Bias-Spannung die chemische Reaktion in den Gasphase und damit die Schichtbildung bewirkten.

Es wurden in dieser Kammer in Serienversuchen die unterschiedlichsten Teile (z.B. Beschläge, Armaturen, Lagerteile) allseitig gleichmäßig und mit reproduzierbaren Ergebnissen beschichtet. Es wurden verchromte sowie vernickelte Teile, Teile aus Edelstahl, gehärtetem Stahl, Aluminium, weiteren Leichtmetallen, auch mit eloxierter Oberfläche, Keramiken, Messing und Glas mit matten oder hochglänzenden Oberflächen mit verschiedensten Schichtdicken und auch vorbestimmten Farb- und -tongebungen beschichtet. In der Versuchskammer betrugen die Beschichtungszeiten für die beschriebenen farbgebenden Schichten mit integriertem Verschleißschutz etwa 30 Minuten.

In den im Anspruch 10 angegebenen Zusammensetzungsbereichen wurden erfolgreich insbesondere verschleißfeste harte Schichten im Bereich von etwa 3 µm bis 8 µm Dicke erzielt, deren Härte über der von Titannitridschichten lag. Die Erfindung ist jedoch nicht auf diese speziellen Gaszusammensetzungen beschränkt, sondern es ist denkbar, z.B. eine die Brechzahl ändernde Komponente zuzusetzen, die die Härte nicht oder nur unwesentlich beeinflußt.

Auch komplizierte beschichtete Gegenstände wie z.B. Türgriffe zeigen im weißen Licht allseitig einen zufriedenstellend homogenen Farbeindruck.

Wie bereits erwähnt, werden durch den Siliziumzusatz sowohl die Brechzahl als auch die Extinktion der diamantartigen Schicht beeinflußt. Auch ändert sich durch den Siliziumzusatz die Beschichtungsgeschwindigkeit.

Bei den Ausführungsbeispielen wurden in der Regel nach Ändern der Gaszusammensetzung und/oder der Gasmengen die elektrischen Bedingungen der Energieeinspeisung geändert und insbesondere angepaßt.

Die Grenzwerte für die Beschichtungsparameter können jedoch leicht allein dadurch empirisch bestimmt werden, daß man kontrolliert, ob bei der Beschichtung der Farbkreis noch durchlaufen wird oder nicht. Diese Art der Steuerung der Schichtdicke, ohne deren realen Dickenwert und Brechungsindex bestimmen zu müssen, hat gegenüber dem weiter oben genannten mehrlagigen Schichtaufbau mit irisierender Wirkung entscheidende Vorteile, da dort die einzelnen Schichtdicken sehr genau vorzugeben und aufeinander abzustimmen sind. Auch ist es erfindungsgemäß ohne weiteres möglich, die Dicke der farbgebenden Beschichtung bzw. des Beschichtungbereichs bei der Beschichtung örtlich zu variieren, z.B. durch Ändern der Geometrieverhältnisse in der Kammer und Beeinflussung des elektrischen Hochfrequenzfeldes in unmittelbarer Nähe vor dem zu beschichtenden Gegenstand, so daß ein mehrfarbiger Gegenstand gewonnen werden kann oder gezielte farbige Übergänge, Farbverläufe und/oder Farbmuster erzeugbar sind.

Im Gegensatz zu dem gattungsgemäßen Stand der Technik wird das Substrat nicht geheizt. Damit verbunden ist eine wesentliche Zeitersparnis, die Materialauswahl ist deutlich größer und es tritt kein Veränderung der Maßhaltigkeit auf. Hierdurch wird nicht nur das Verfahren kostengünstiger, sondern es können auch empfindliche Substrate mit den farbgebenden Schichten versehen und zusätzlich sehr effektiv geschützt werden.

## Patentansprüche

1. Verfahren zur Herstellung einer dünnen Beschichtung durch plasma unterstützte chemische Gasphasenabscheidung aus einer Kohlenstoff, Wasserstoff und Silizium enthaltenden Gasphase vorgegebener Zusammensetzung auf einer Substratoberfläche in Form einer diamantartigen, Kohlenstoff, Wasserstoff und Silizium haltigen Verbindung, **dadurch gekennzeichnet,**
**daß** in einem einzigen Vakuum-Beschichtungsprozeß
a) im an die Substratoberfläche angrenzenden Teil der Beschichtung zunächst bis zu einer vorgegebenen Dicke ein nicht farbgebender, für Härte und Verschleißfestigkeit der gesamten Beschichtung sorgender Schichtbereich aufgebracht wird,
b) daß anschließend mindestens eine Reflexionsgrenzfläche durch eine stetige oder sprungartige Änderung der Beschichtungsparameter: Zusammensetzung der schichtbildenden Gasphase und/oder elektrische Parameter der Energieeinspeisung und einen dadurch hervorgerufenen Gradienten der Schichtzusammensetzung und Brechzahl gebildet wird, und
c) daß an der jeweiligen optischen Reflexionsgrenzfläche weiterbeschichtet wird, bis ein sich an die optische Reflexionsgrenzfläche anschließender farbgebender Schichtbereich eine optische Schichtdicke aufweist, die nach dem Prinzip der Interferenz an dünnen Plättchen durch Interferenzen erster und/oder höherer Ordnung an den Grenzflächen dieses farbgebenden Schichtbereichs auf das ein- oder ganzzahlige mehrfache der Wellenlänge des gewünschen Farbeindrucks abgestimmt ist,
wobei in den Schritten b) und c) des Vakuum-Beschichtungsprozesses bei der Einstellung der Beschichtungsparameter keine spürbaren, den Zusammenhalt und die gesamte Härte des Schichtsystems bei vorgegebener mechanischer Belastung beeinträchtigende Sprünge in den mechanischen Eigenschaften erzeugt werden.

2. Verfahren nach Anspruch 1,
**dadurch gekennzeichnet**,
der nicht farbgebende Schichtbereich als im sichtbaren Bereich nicht notwendigerweise optisch durchlässiger Bereich aufgebracht wird.

3. Verfahren nach Anspruch 1 oder 2,
**dadurch gekennzeichnet,**
**daß** zur Erzielung des oder der Gradienten der Schichtzusammensetzung und Brechzahl kurz vor Erreichen der Gesamtdicke der Beschichtung die Zusammensetzung und Zuflußmenge der schichtbildenden Gase und Dämpfe und/oder die elektrischen Parameter der Energieerzeugung stetig oder sprungartig verändert werden, um zu dem oder den darüber abzuscheidenden farbgebenden Schichtbereichen abweichender Brechzahl die mindestens eine optische Reflexionsgrenzfläche zu bilden, deren Reflexionsgrad zur Einstellung der Farbhelligkeit variiert wird.

4. Verfahren nach Anspruch 1, 2 oder 3,
**dadurch gekennzeichnet,**
**daß** zur Erzeugung einer in die Beschichtung integrierten Reflexionsfläche eine dünne Schicht abweichender Brechzahl zwischen dem nicht farbgebenden und dem farbgebenden Bereich der Beschichtung erzeugt wird, wobei über die Dicke dieser Reflexionsschicht der Grad einer resultierenden abgeschwächten Totalreflexion gesteuert wird.

5. Verfahren nach einem der vorhergehenden Ansprüche,
**dadurch gekennzeichnet,**
**daß** während der Erzeugung der farbgebenden Beschichtung bzw. des oder der farbgebenden Bereiche das Durchlaufen des Farbkreises des mit der Schichtdicke variierenden Farbeindrucks beobachtet wird und bei Erreichen des gewünschten Farbeindrucks die Beschichtung beendet wird.

6. Verfahren nach einem der vorhergehenden Ansprüche,
**dadurch gekennzeichnet,**
**daß** das Silizium in Form des Dampfes einer verdampfbaren siliziumorganischen Verbindung, insbesondere Hexamethyldisilan (HDMS), Tetramethylsilan, Hexamethyldisiloxan (HDMSO), Tetraethoxisilan (TEOS) und/oder Tetramethyldisilazan den übrigen Arbeitsgasstoffen beigemischt wird.

7. Verfahren nach einem der vorhergehenden Ansprüche,
**dadurch gekennzeichnet,**
**daß** das Arbeitsgas neben Silizium und Wasserstoff als den Kohlenstoff lieferndes Gas Alkane, Alkene und/oder Alkine, insbesondere Ethin oder aromatische Kohlenwasserstoffe wie Benzol enthält.

8. Verfahren nach einem der vorhergehenden Ansprüche,
**dadurch gekennzeichnet,**
**daß** der Gasdruck bei der Erzeugung der farbgebenden Beschichtung zwischen 0,005 und 1 mbar liegt.

9. Verfahren nach Anspruch 8,
**dadurch gekennzeichnet,**
**daß** der Gasdruck zwischen 0,05 und 0,1 mbar beträgt.

10. Verfahren nach einem der vorhergehenden Ansprüche,
**dadurch gekennzeichnet,**
**daß** das Arbeitsgas zusammengesetzt wird aus Ethin, Wasserstoff und Hexamethyldisiloxan mit einem molaren Mischungsverhältnis von 1 : 1 : 0,5 bis 1 : 0,01 : 0,005, wobei zur Erzeugung des nicht farbgebenden, harten und verschleißfesten Basisschichtbereichs und der farbgebenden Bereiche die Zusammensetzung des Arbeitsgases innerhalb dieser Grenzen stetig oder sprungartig verändert wird.

11. Verfahren nach einem der vorhergehenden Ansprüche,
**dadurch gekennzeichnet,**
**daß** zur elektrischen Energieeinspeisung zur Erzeugung des Plasmas Einzelanregungen oder deren Kombinationen verwendet werden, wie Gleichspannung, mono- und bipolare Gleichspannungs-Pulstechnik, Mittelfrequenz (typischerweise 30-60 kHz), Hochfrequenz im Megahertzbereich (typischerweise 13,56 MHz) oder Mikrowellenanregung bei typischerweise 2,45 GHz.

12. Verfahren nach einem der vorhergehenden Ansprüche,
**dadurch gekennzeichnet,**
**daß** die Energieeinspeisung zur Erzeugung des Plasmas so gewählt wird, daß die verwendeten Gase und Dämpfe ionisiert werden und sich durch ein elektrisches Feld in diamantartiger Struktur auf den Substratoberflächen abscheiden, wobei bei Hochfrequenz-Anregung die Gasentladungs-Anregungsfrequenz im Bereich von 1 bis 50 MHz, insbesondere auf 13,56 MHz eingestellt wird.

13. Verfahren nach einem der vorhergehenden Ansprüche,
**dadurch gekennzeichnet,**
**daß** die sich bei brennender Plasmaentladung von selbst am Substrat einstellende Spannung, die sog. Self-Bias-Komponente, abhängig vom Gasdruck, den Geometrieverhältnissen, den jeweiligen Substraten und der Plasmaleistung zwischen 100 V und 1500 V als vorgegebener Wert eingeregelt wird.

14. Verfahren nach einem der vorhergehenden Ansprüche,
**dadurch gekennzeichnet,**
**daß** während der Erzeugung der farbgebenden Beschichtung bzw. der Beschichtungsbereiche die Schichtdicke durch Veränderung der Beschichtungsgeometrie, Elektrodenanordnung und/oder Gasführung örtlich variiert wird, um verschiedene farbige Schichtbereiche, Farbübergänge oder Farbmuster zu erzielen, oder in einem zweiten oder mehreren anschließenden Beschichtungsschritten mehrere unterschiedliche Farben erzeugt werden.

15. Verfahren nach einem der vorhergehenden Ansprüche,
**dadurch gekennzeichnet,**
**daß** Teile aus Metall, metallisierten Kunststoffen, Keramiken und Glas verschiedener 3-dimensionaler Formen, mit unterschiedlichen Oberflächenbearbeitungen und -Strukturen beschichtet werden.

16. Verfahren nach einem der vorhergehenden Ansprüche,
**dadurch gekennzeichnet,**
**daß** das Gesamtsystem mit einer Schichtdicke von 1 bis 10 µm aufgebracht wird.

## Claims

1. Method of producing a thin coating by means of a plasma-assisted chemical vapor deposition from a gas phase of a predetermined composition containing carbon, hydrogen and silicon on a substrate surface in the form of a diamond-like compound containing carbon, hydrogen and silicon, **characterized in that**
in a single vacuum coating process:
a) in a coating region adjacent to the substrate surface, first of all, a non-colorating layer region, which provides hardness and wear resistance of the complete coating, is applied up to a predetermined thickness,
b) that subsequently at least one reflection boundary is created by continuously or stepwise changing the coating parameters: composition of the layer forming gas phase and/or electrical parameters of energy supply, and by a gradient of the layer composition and of the refractive index caused thereby and
c) that at the respective reflection boundary, the coating process is continued until a colorating portion adjacent said optical reflection boundary has an optical layer thickness which, according to the principle of interference at thin films, is matched to the single-value or integral multiple of the wave length of the desired color impression by means interferences of the first order and/or of a higher order at the boundaries of said colorating portion,
wherein, in steps b) and c) of the vacuum coating process, when adjusting the coating parameters, no considerable steps in the mechanical characteristics are created, which steps would impede the coherence and the overall hardness of the layer system at a predetermined mechanical loading.

2. Method according to claim 1, **characterized in that** the non-colorating layer region is applied as a not necessarily optically translucent portion in the visible region.

3. Method according to claim 1 or 2, **characterized in that** for obtaining the gradient or gradients of the layer composition and of the refractive index, shortly before reaching the complete thickness of the coating, the composition and supplied quantity of the layer forming gases and vapors and/or the electrical parameters of the energy supply are continuously or stepwise varied such that said at least one optical reflection boundary, the reflection degree of which is varied for adjusting the color brightness, is formed for the colorating layer region or regions of a different refractive index to be deposited on this boundary.

4. Method according to claim 1, 2 or 3, **characterized in that** for producing a reflection surface integrated in the coating, a thin layer of a different refractive index is produced between the non-colorating and the colorating region of the coating, whereby the degree of a resulting diminished total reflection is controlled by means of the thickness of said reflection layer.

5. Method according to one of the preceding claims, **characterized in that**, while producing the colorating layer or the colorating regions, respectively, passing through the color spectrum of the color impression varying with the layer thickness is monitored and the coating process is stopped as soon as the desired color impression is achieved.

6. Method according to one of the preceding claims, **characterized in that** the silicon is admixed in form of the vapor of a vaporable silicon-organic compound, particularly hexamethyl-disilane (HDMS), tetramethyl-silane, hexamethyl-disiloxane (HDMSO), tetraethoxisilane (TEOS) and/or tetramethyl-disilazane to the other working gas substances.

7. Method according to one of the preceding claims, **characterized in that** the working gas contains, besides silicon and hydrogen, as the carbon supplying gas alkane, alkane and/or alkine, particularly ethine or aromatic hydrocarbons such as benzene.

8. Method according to one of the preceding claims, **characterized in that** the gas pressure lies between 0,005 and 1 mbar when producing the colorating layer.

9. Method according to claim 8, **characterized in that** the gas pressure lies 0,05 and 0,1 mbar.

10. Method according to one of the preceding claims, **characterized in that** the working gas is composed of ethine, hydrogen and hexamethyl-disiloxane with a molar mixture ratio of 1 : 1 : 0,5 to 1 : 0,01 : 0,005, whereby, for producing of the non-colorating, hard and wear resistant base layer region and the colorating regions the composition of the working gas is continuously or stepwise changed within said ranges.

11. Method according to one of the preceding claims, **characterized in that**, for the electrical energy supply for producing the plasma, individual excitations or their combinations are used, such as direct-voltage, mono-polar and bi-polar direct-voltage pulse-technics, medium frequency (typically 30 - 60 kHz), high-frequency in the MHz-range (typically 13,56 MHz) or microwave-excitation at typically 2,45 GHz.

12. Method according to one of the preceding claims, **characterized in that** the energy supply for producing the plasma is chosen such that the used gases and vapors are ionized and are deposited by means of an electrical field preferably in a diamond-like structure on the substrate surfaces, whereby, during high-frequency excitation, the gas-discharging excitation frequency is adjusted within a range of 1 to 50 MHz, particularly at 13,56 MHz.

13. Method according to one of the preceding claims, **characterized in that** the voltage automatically developing at the substrate during the burning plasma discharge, the so-called self-bias-component, is adjusted between 100 V and 1500 V as a predetermined value, depending on the gas pressure, the geometric configurations, the corresponding substrates and on the plasma power.

14. Method according to one of the preceding claims, **characterized in that**, while producing the colorating coating of the coating regions, respectively, the layer thickness is locally varied by changing the coating geometry, arrangement of electrodes and/or gas supply, for obtaining differently colored layer portions, color transitions or color patterns, or, that in a second coating step or in a plurality of subsequent coating steps, a plurality of different colors are produced.

15. Method according to one of the preceding claims, **characterized in that** parts of metals, metallized plastics, ceramics and glass of different three-dimensional shapes with different surface treatments and different surface structures are coated.

16. Method according to one of the preceding claims, **characterized in that** the total system is applied with a layer thickness of 1 to 10 µm.

## Revendications

1. Procédé pour la fabrication d'un revêtement par séparation chimique à phase gazeuse plasma à partir d'une composition prédéfinie contenant du carbone fin, de l'hydrogène et du silicium sur une surface substrat sous forme d'une liaison de type diamant contenant du carbone, de l'hydrogène et du silicium, **caractérisé en ce que** en un seul processus de revêtement sous vide
a) dans la partie adjacente à la surface substrat du revêtement, une couche non colorante servant à durcir et à rendre résistant à l'usure l'ensemble du revêtement est d'abord appliquée jusqu'à une profondeur prédéfinie,
b) ensuite, au moins une surface adjacente de réflexion est composée par modification continue ou graduelle des paramètres de revêtement : composition de la phase gazeuse constituant la couche et/ou paramètres électriques d'alimentation énergétique et par un gradient de la composition de la couche et un taux de rupture en résultant, et
c) on continue à revêtir la surface limite optique respective de réflexion, jusqu'à ce qu'apparaisse une épaisseur de couche optique sur la zone colorante de couche contiguë à la surface adjacente de réflexion, qui est déterminée selon le principe de l'interférence sur les plaquettes minces par des interférences de premier ordre et/ou d'ordre plus élevé sur les surfaces adjacentes de cette zone de couche colorante sur la longueur unique ou multipliée des ondes de l'impression colorée désirée,
aucun bond perceptible influant sur la dureté totale du système de couche en cas de sollicitation mécanique dans les propriétés mécaniques ne se produisant dans les étapes b) et c) du processus de revêtement sous vide lors du réglage des paramètres de revêtement.

2. Procédé selon la revendication 1, **caractérisé en ce que** la zone de couche non colorante est appliquée, dans la zone visible et non impérativement sous forme d'une zone transparente du point de vue optique.

3. Procédé selon la revendication 1 ou 2, **caractérisé en ce que** pour atteindre le ou les gradient(s) de la composition de couche et le taux de rupture juste avant d'arriver à l'épaisseur totale du revêtement, la composition et la quantité d'afflux des gaz et vapeurs formant la couche et/ou les paramètres électriques de la production d'énergie sont modifiés en continu ou graduellement, pour constituer au moins une couche adjacente de réflexion optique sur la ou des zone(s) de couche colorante de taux de rupture différent à revêtir, dont le degré de réflexion est varié pour régler l'éclat de la couleur.

4. Procédé selon la revendication 1, 2 ou 3 **caractérisé en ce que** pour l'élaboration d'une surface réfléchissante intégrée dans le revêtement, une couche mince à taux de rupture différent est réalisée entre la zone non colorante et la zone colorante du revêtement, le degré de réflexion totale affaiblie en résultant étant contrôlé sur l'épaisseur de cette couche réfléchissante.

5. Procédé selon une des revendications précédentes, **caractérisé en ce que** pendant l'élaboration du revêtement colorant ou de la ou des zone(s) colorantes, on suit la progression du cercle chromatique de l'impression colorée variant en fonction de l'épaisseur de la couche et on achève le revêtement lorsque l'impression colorée souhaitée est atteinte.

6. Procédé selon une des revendications précédentes, **caractérisé en ce que** le silicium sous forme de vapeur ou d'une liaison organique de silicium pouvant être vaporsisée, tout particulièrement de l'héxazméthyldisilane (HDMS), du tétraméthylsilane, de l'héxaméthyldisiloxane (HDMSO), du tétraéthoxysilane (TEOS) et/ou du tétraméthyldisilazane, est mélangé aux autres gaz opérationnels.

7. Procédé selon une des revendications précédentes, **caractérisé en ce que** le gaz opérationnel, outre du silicium et de l'hydrogène, contient, comme gaz produisant le carbone, de l'alcane, de l'alcène et/ou de l'alcine, tout particulièrement de l'éthine ou des hydrocarbures aromatiques comme le benzène.

8. Procédé selon une des revendications précédentes, **caractérisé en ce que** la pression du gaz, lors de l'élaboration du revêtement colorant, se situe entre 0,005 et 1 mbar.

9. Procédé selon la revendication 8, **caractérisé en ce que** la pression du gaz se situe entre 0,05 et 0,1 mbar.

10. Procédé selon une des revendications précédentes, **caractérisé en ce que** le gaz opérationnel est constitué d'éthine, d'hydrogène et d'héxaméthyldisiloxane avec un rapport molaire de mélange de 1 : 1 : 0,5 à 1 : 0,01 : 0,005, la composition du gaz opérationnel pour l'élaboration de la zone de couche basique non colorante, dure et résistante à l'usure et des zones colorantes, étant modifiée en continu ou graduellement à l'intérieur de ces limites.

11. Procédé selon une des revendications précédentes, **caractérisé en ce que** pour l'alimentation en énergie électrique pour l'élaboration du plasma des impulsions isolées ou leurs combinaisons sont utilisées, comme la tension continue, la technique de pulsation à courant continu mono et bi-polaire, la fréquence moyenne (typiquement 30-60 kHz), la haute fréquence dans le secteur mégahertz (typiquement 13,56 MHz) ou l'impulsion micro-ondes à une valeur typique de 2,45 GHz.

12. Procédé selon une des revendications précédentes, **caractérisé en ce que** l'alimentation énergétique pour la production du plasma est choisie de manière à ce que les gaz et vapeurs utilisés soient ionisés et se déposent par l'intermédiaire d'un champ électrique en structure de type diamant sur les surfaces substrats, la fréquence d'impulsion de décharge de gaz étant réglée, en cas d'impulsion à haute fréquence, dans une fourchette de 1 à 50 MHz, tout particulièrement à 13,56 MHz.

13. Procédé selon une des revendications précédentes, **caractérisé en ce que** la tension s'installant d'elle-même sur le substrat en cas de décharge de plasma brûlant, appelée composante à auto-distorsion, se règle en fonction de la pression du gaz, des rapports géométriques, des substrats respectifs et de la puissance du plasma entre 100 V et 1500 V en tant que valeur prédéfinie.

14. Procédé selon une des revendications précédentes, **caractérisé en ce que** pendant l'élaboration du revêtement colorant ou des zones de revêtement, l'épaisseur de couche varie localement par modification de la géométrie de revêtement, du positionnement des électrodes et/ou de l'apport en gaz, pour obtenir différentes zones de couches colorées, des transitions de couleurs ou des modèles de couleur, ou, dans une deuxième ou plusieurs étapes consécutives de revêtement, plusieurs couleurs différentes sont élaborées.

15. Procédé selon une des revendications précédentes, **caractérisé en ce que** des pièces en métal, plastiques métallisés, céramiques et verre de formes tridimensionnelles variées sont revêtues de divers traitements et structures de surface.

16. Procédé selon une des revendications précédentes, **caractérisé en ce que** l'ensemble du système est appliqué avec une épaisseur de couche de 1 à 10 µm.
